# FASCICULE DE BREVET EUROPEEN

(11) **EP 0 593 340 B1**
(45) Date de publication et mention de la délivrance du brevet: **27.03.2002**
(21) Numéro de dépôt: 93402470.4
(22) Date de dépôt: 07.10.1993
(51) Int. Cl.: G06T 17/00, B41M 1/40, B44D 2/00

(54) **Procédé et dispositif d'aide à la décoration d'un objet tridimensionnel**
Verfahren und Vorrichtung zur Erleichterung der Dekoration eines dreidimensionalen Gegenstandes
Process and apparatus facilitating the decoration of a three-dimensional object

(30) Priorité: 12.10.1992 FR 9212146
(43) Date de publication de la demande: 20.04.1994
(73) Titulaire: AEROSPATIALE Société Nationale Industrielle, 75781 Paris Cédex 16 (FR)
(72) Inventeur: Jarrige, Marie Claude, F-31880 La Salvetat St Gilles (FR); Jarrige, Jean-Luc, F-31880 La Salvetat St Gilles (FR); Delille, Annie, F-31700 Blagnac (FR); Lainez, Vincent, F-31170 Tournefeuille (FR)
(74) Mandataire: Dubois-Chabert, Guy

(56) Documents cités:
- EP-A- 0 198 630
- EP-A- 0 290 809
- EP-A- 0 371 897
- EP-A- 0 431 239
- COMPUTER-AIDED DESIGN vol. 23, no. 8 , Octobre 1991 , LONDON, GB pages 583 - 592 XP236521 B. K. HINDS ET. AL. 'PATTERN DEVELOPMENT FOR 3D SURFACES'

## Description

L'invention concerne un procédé d'aide à la décoration d'un objet tridimensionnel, ainsi qu'un dispositif de mise en oeuvre de ce procédé.

Elle s'applique notamment à la décoration d'objets volumineux par des logos, signes, lettres ou figures distinctives qui peuvent être peints sur la surface de ces objets. Elle s'applique plus particulièrement, à la décoration d'aéronefs et, plus précisément, à la décoration de la surface externe d'un avion par des logos, signes, lettres ou figures distinctives, choisis par la compagnie aérienne exploitant cet avion.

Dans la description qui va suivre, l'invention va être décrite dans son application à la décoration d'avions, cette application n'étant cependant pas limitative.

Généralement, la peinture des avions consiste tout d'abord à appliquer des sous-couches de peinture de protection, puis à appliquer, sur ces sous-couches, une peinture dite de "fond", généralement de couleur blanche. C'est sur cette peinture de fond que sont appliqués les logos, signes, figures ou lettres distinctives, choisis pour décorer l'avion, par la compagnie aérienne exploitant l'avion.

Dans le but de protéger son image commerciale, chaque compagnie aérienne exige du constructeur d'un avion, une décoration parfaite, notamment pour tous les signes et logos distinctifs peints sur la surface externe de l'avion.

Cette décoration externe est généralement réalisée de façon relativement artisanale et nécessite une succession d'opérations très minutieuses faisant suite aux difficultés rencontrées par les peintres et décorateurs spécialisés, pour imaginer dans un espace en trois dimensions l'aspect qu'auront les logos, signes distinctifs, etc. représentés au départ en deux dimensions, sur des plans. En effet, la compagnie aérienne, cliente du constructeur, représente la plupart du temps la décoration souhaitée en deux dimensions sur un plan. Si une représentation de l'avion et de sa décoration est fournie au constructeur, elle ne peut être qu'approximative et, de toute façon, inutilisable pour être transposée directement sur l'avion, même après agrandissement, du fait notamment que le choix des dimensions et de l'emplacement de cette décoration sur l'avion dépend de la forme de cet avion. Généralement, un choix définitif de décoration ne peut être effectué qu'après réalisation d'un premier prototype de décoration sur un avion ; ce prototype est soumis à diverses retouches nécessitant à chaque fois un effaçage au moins partiel de la décoration. Ce processus est long et coûteux, bien que les plans descriptifs de la décoration représentée en deux dimensions puissent être réalisés par C.A.O. (Conception Assistée par Ordinateur) et que les dimensions et positions caractéristiques de la décoration soient définies par des cotes sur ces plans.

Les plans obtenus par C.A.O. sont fournis à la compagnie aérienne par le constructeur, ou résultent d'une collaboration entre la compagnie aérienne et le constructeur. L'obtention de plans en C.A.O. n'évite pas la réalisation d'une décoration prototype d'un premier avion, ainsi que les retouches mentionnées plus haut et les corrections des plans initiaux, rendues nécessaires par ces retouches. Ce n'est que lorsque la compagnie aérienne considère satisfaisant l'aspect de la décoration prototype, qu'un plan définitif peut enfin être validé.

Lorsque le prototype de décoration réelle sur un avion est ainsi validé, une série de poncifs (feuilles percées de trous de repérage) sont relevés sur cet avion, en vue de reproduire une décoration identique sur les autres avions de la compagnie aérienne concernée. Chaque poncif est constitué d'un film translucide et plan, sur lequel on réalise des perforations situées sur des lignes essentielles à la définition de la décoration. On utilise ensuite des moyens de repérage pour positionner le poncif ainsi obtenu, sur les objets à décorer. Ces moyens de repérage sont des références de positionnement du poncif sur chaque avion. Ils doivent être positionnés de manière précise par rapport à des contours caractéristiques d'éléments de l'avion, par exemple les bords des hublots ou des portes. Les poncifs sont alors archivés et réutilisés pour les avions de même type d'une compagnie.

Le procédé qui vient d'être décrit présente un inconvénient majeur : il est difficile de reproduire, sur un objet en trois dimensions, un tracé qui a été réalisé sur un plan bidimensionnel. Un autre inconvénient résulte du fait que la qualité du relevé, sur un poncif, du prototype validé de décoration d'un avion, conditionne la qualité de la reproduction de la décoration sur les autres avions.

Un autre inconvénient majeur provient de la difficulté de plaquer parfaitement un poncif plan sur un support de forme évolutive. Enfin, les poncifs qui sont souvent de grandes dimensions et toujours nombreux posent des problèmes d'archivage et leur renouvellement doit être prévu à la suite de plusieurs utilisations.

Un procédé plus récent permet de découper de façon automatisée, des pochoirs (feuille découpée à la forme souhaitée) de décoration destinés à être appliqués sur une surface tridimensionnelle, telle que le fuselage d'un avion. La peinture de la décoration, en particulier lorsqu'un pochoir est utilisé, est généralement effectuée au pistolet. Le procédé de découpe consiste à utiliser un système de traitement et un programme adapté de C.A.O. pour obtenir un modèle tridimensionnel représentatif de la surface externe d'un avion à décorer et un modèle bidimensionnel d'une image de la décoration projetée dans un plan intermédiaire ; le système de traitement et le programme permettent aussi de positionner le modèle bidimensionnel par rapport à des références de positionnement choisies sur le modèle tridimensionnel. Le procédé consiste ensuite à effectuer des calculs de projection pour obtenir une représentation tridimensionnelle de la décoration correctement positionnée sur le modèle tridimensionnel. Les données de représentation tridimensionnelle de la décoration et de l'avion sont enregistrées. Le système de traitement commande alors des moyens de découpage de pochoirs nécessaires à la décoration et des moyens de repérage, sur ces pochoirs, de références de positionnement.

Le procédé qui vient d'être décrit présente, lui aussi, des inconvénients :

L'obtention d'un pochoir acceptable pour la décoration d'un premier avion résulte souvent de la découpe de plusieurs pochoirs successifs servant à des essais de décoration sur l'avion, ce qui est coûteux et pénalisant. Les pochoirs comme les poncifs doivent eux aussi être archivés et leur renouvellement doit être prévu après plusieurs utilisations, voire après une seule utilisation, si ces pochoirs sont autocollants.

Un autre procédé décoration d'un objet est divulgué dans le document EP-A-0 371 897; il consiste à prendre une ébauche (film) sur laquelle on localise certains points caractéristiques du tracé de la décoration et à positionner des moyens de déformation de la décoration en tenant compte des modifications des positions desdits points caractéristiques.

La présente invention a pour but de remédier aux inconvénients des procédés connus, notamment en évitant l'utilisation de pochoirs prédécoupés, coûteux et dont le cycle de fabrication est pénalisant, notamment en cas de retouches.

De façon plus précise, l'invention concerne un procédé d'aide à la décoration d'un objet tridimensionnel, consistant :
- à construire un modèle en trois dimensions de l'objet décoré par un tracé de la décoration, visualisable par au moins une image ;
- à localiser sur ledit objet, au moins certains points caractéristiques dudit tracé, à partir du modèle 3D de l'objet et du tracé de la décoration,
caractérisé en ce qu'il consiste à modéliser l'objet décoré :
- en construisant un modèle mathématique 3D de l'objet à décorer, par Conception Assistée par Ordinateur (C.A.O.), de type surfacique ou volumique, ce modèle de l'objet décoré étant visualisable par au moins une image ;
- en superposant audit modèle de l'objet, au moins un modèle mathématique 3D du tracé de la décoration souhaitée de l'objet, visualisable par au moins une image obtenue par C.A.O.

Selon une autre caractéristique, le procédé consiste à modéliser l'objet décoré :
- en construisant un modèle mathématique 3D de l'objet à décorer, ce modèle étant obtenu à partir de mesures géométriques directes sur l'objet, le modèle 3D étant alors visualisable par au moins une image ;
- en superposant audit modèle de l'objet, au moins un modèle mathématique 3D du tracé de la décoration souhaitée de l'objet, visualisable par au moins une image.

Selon une autre caractéristique, le procédé consiste à positionner sur l'objet des moyens de délimitation de la décoration, à partir desdits points caractéristiques localisés sur l'objet.

Le procédé de l'invention a notamment pour avantage de permettre des retouches directes de l'image de la décoration sur celle de l'objet, visualisée dans une représentation tridimensionnelle.

L'invention a aussi pour objet un dispositif permettant de mettre en oeuvre le procédé précédent. Ce dispositif est caractérisé en ce qu'il comporte :
- un système de traitement de données commandé par un logiciel spécialisé de Conception Assistée par Ordinateur, pour obtenir une représentation tridimensionnelle d'un modèle de l'objet à décorer, et une représentation tridimensionnelle, d'un modèle du tracé de la décoration souhaitée de l'objet, le modèle du tracé étant superposé au modèle de l'objet ;
- des moyens de mémorisation reliés au système de traitement pour enregistrer des coordonnées d'au moins une pluralité de points caractéristiques du tracé de la décoration, repérés par rapport à des points de référence de l'objet ;
- des moyens pour localiser sur ledit objet au moins les points caractéristiques du tracé de la décoration.

Cette localisation consiste en fait à projeter en grandeur réelle sur l'objet, une image du tracé de la décoration, représenté en totalité ou au moins par une pluralité de points caractéristiques de ce tracé. Des moyens de projection lumineuse peuvent être utilisés. Ils nécessitent bien entendu un calage initial d'orientation et de position.

Selon une autre caractéristique du dispositif, les moyens de projection lumineuse comportent une source lumineuse et des moyens de commande de déplacement et d'orientation de la source lumineuse pour projeter sur l'objet lesdits points caractéristiques du tracé, à partir desdites coordonnées enregistrées.

Selon un autre mode de réalisation du dispositif, les moyens de commande de déplacement et d'orientation de la source lumineuse sont reliés au système de traitement.

Selon une variante de réalisation, la source lumineuse est une source laser.

Selon une autre variante de réalisation, le dispositif comporte un moyen de projection d'images de la décoration sur l'objet.

Selon une autre caractéristique, le dispositif comporte des index adhésifs ou des marques effaçables pour repérer lesdits points caractéristiques localisés sur l'objet par projection lumineuse.

Selon une autre caractéristique, le dispositif comporte des moyens de délimitation de la décoration, positionnés sur l'objet, à partir des positions desdits index ou marques de repérage.

Selon une caractéristique particulière, lesdits moyens de délimitation de la décoration sont des bandes adhésives ou des pochoirs.

Selon une autre caractéristique particulière, lesdits moyens de délimitation de la décoration sont des éléments autocollants.

Selon une variante de réalisation, les moyens pour localiser lesdits points caractéristiques sur ledit objet sont des moyens de projection d'image de la décoration sur ledit objet.

Selon une autre caractéristique, les moyens pour localiser le tracé de la décoration sur ledit objet comportent un moyen de découpage d'une couche sensible adhérant à l'objet, pour faire apparaître des zones de cette couche correspondant à des zones de la décoration, lesdites zones de la couche sensible étant pelables.

Selon une autre variante de réalisation, le dispositif comporte un robot distributeur d'un matériau polymérisable sous forme d'un film de masquage à la surface dudit objet, ce film délimitant la décoration et le robot étant commandé par ledit système de traitement.

Enfin, selon une autre variante de réalisation, le dispositif comporte un robot commandé par le système de traitement pour poser des bandes, pochoirs ou index adhésifs de repérage ou de délimitation de la décoration.

Les caractéristiques et avantages de l'invention apparaîtront au cours de la description qui va suivre, donnée à titre illustratif, mais non limitatif, en référence aux dessins annexés dans lesquels :
- la figure 1 est une vue schématique du dispositif permettant la mise en oeuvre du procédé selon l'invention ;
- la figure 2 est un organigramme représentant les étapes essentielles du procédé selon l'invention ;
- les figures 3 et 4 permettent de mieux comprendre des opérations intervenant dans des étapes du procédé de l'invention ; et
- la figure 5 représente schématiquement le fuselage d'un avion en cours de décoration.

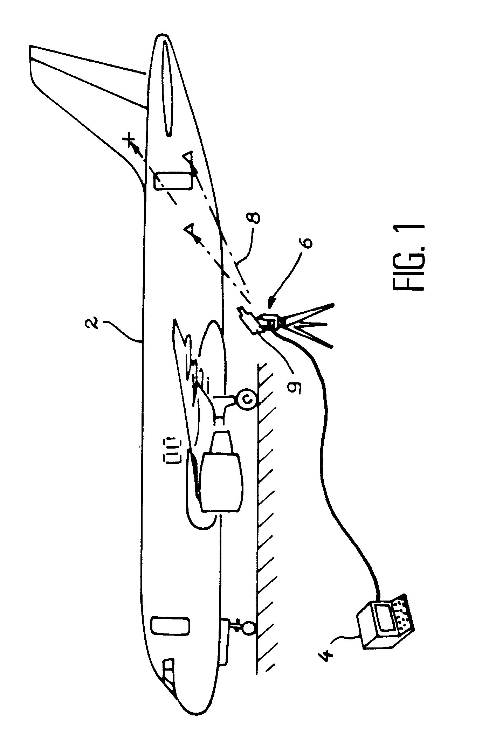

Sur la figure 1, on a représenté schématiquement un mode de réalisation du dispositif de l'invention qui comporte essentiellement un télémètre 6 à faisceau laser 8, relié à un système 4 de traitement de données. Ce télémètre 6 est utilisé, comme on le verra plus loin en détail, pour localiser, grâce à son faisceau, des points de repère sur un avion 2 ; ces points permettent ensuite de positionner avec précision, des moyens de délimitation et notamment des masques, des bandes ou des pochoirs de délimitation de la décoration souhaitée qui est effectuée par exemple par application d'une ou de plusieurs peintures de différentes couleurs dans des zones ainsi délimitées.

Le télémètre utilisé est de type connu, et ne sera pas décrit en détail. Il comporte notamment une lunette grossissante (non représentée sur la figure) permettant de faire des visées en vue du calage initial du télémètre par rapport à des repères de référence liés à l'avion. C'est ce calage qui permet ensuite d'effectuer avec précision la projection sur l'avion du tracé de la décoration ou de points caractéristiques de repérage de ce tracé. La source laser du télémètre émet un faisceau laser 8 dont l'impact sur l'avion est un point caractéristique du tracé de la décoration. Comme on le verra plus loin en détail, les coordonnées de chaque point caractéristiques ont été déterminées par le système de traitement 4 utilisant des données de C.A.O. Ces coordonnées sont déterminées dans un repère de référence. Les coordonnées sont enregistrées dans une mémoire du système de traitement. Le système de traitement 4 ne sera pas décrit ici en détail. Il comporte par exemple un microordinateur avec écran et clavier de commande. D'autres modes de réalisation du dispositif de l'invention seront décrits plus loin en détail.

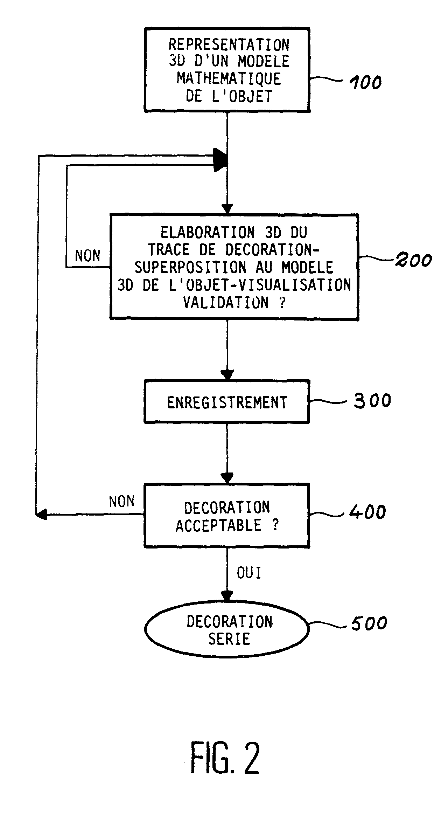

La figure 2 est un organigramme montrant les étapes essentielles du procédé de l'invention. Les détails concernant ces étapes essentielles seront donnés plus loin.

Ce procédé comporte une étape 100 qui consiste à composer un fichier informatique 3D de définition d'un modèle mathématique ou virtuel de l'avion à décorer. Les données de ce fichier sont établies à partir de logiciels spécialisés qualifiés de "surfaciques" ou "volumiques", car relatifs à la surface ou au volume de l'objet. Ces logiciels sont commercialisés par exemple sous les marques AEROLLS ou CATIA. Ce fichier doit également contenir des données de références de repérage pour pouvoir définir correctement le tracé de la décoration et son positionnement sur l'avion. Le fichier 3D de définition du modèle de l'avion à décorer peut être constitué à partir de fichiers provenant de différents partenaires ayant participé à la définition et à la construction de l'avion. Il peut également être établi par mesures géométriques sur l'avion, par exemple à l'aide d'un mètre, ou par photogrammétrie. L'étape suivante 200 consiste à élaborer un modèle mathématique 3D du tracé de la décoration, à l'aide d'un logiciel spécialisé qui peut être l'un des logiciels mentionnés plus haut.

Des images de l'avion décoré peuvent alors être obtenues informatiquement sur l'écran de visualisation du système 4 de traitement (figure 1). Cette opération de visualisation est une simulation de l'image de l'avion décoré.

Après validation par la compagnie aérienne, les données de ce modèle du tracé de la décoration sont figées dans un fichier qui donne une définition précise de la décoration dans les trois dimensions. L'obtention de ce fichier 3D d'un modèle de la décoration sera décrite plus loin en détail. Le fichier 3D d'un modèle de la décoration étant établi, l'étape 200 consiste alors à superposer le modèle 3D du tracé de la décoration, au modèle 3D de l'avion à décorer. Cette superposition utilise notamment les données de référence de positionnement contenues dans le fichier 3D du modèle de l'avion. Le fichier obtenu est alors un fichier 3D de l'avion décoré.

Comme on le verra plus loin en détail, l'obtention d'un fichier 3D de la décoration peut être le résultat d'un traitement d'un fichier 2D de la décoration représentée dans un plan.

Les logiciels C.A.O. (3D) surfacique ou volumique ne permettent pas de modifier directement le tracé d'une courbe obtenue en C.A.O., sur une surface, elle aussi, obtenue en C.A.O.

Pour effectuer cette modification, il est nécessaire de positionner un point sur la surface et ensuite d'infléchir la courbe pour qu'elle passe par ce point. Rien ne prouve cependant, compte tenu des formes de la surface d'un avion, que la nouvelle courbe obtenue en C.A.O. soit en permanence en contact avec la surface de l'avion obtenue en C.A.O. On est alors obligé de projeter cette nouvelle courbe sur la surface. Il est alors certain que la courbe visualisée est bien plaquée sur la surface du modèle 3D.

La compagnie aérienne a défini la décoration dans un plan 2D. Cette définition n'est pas totalement satisfaisante car elle est donnée dans un plan et n'est pas le résultat de projections. Il n'est donc pas sûr que le tracé de la décoration sur l'avion corresponde bien aux souhaits de la compagnie aérienne. La méthode de projection qui vient d'être décrite peut donc donner un résultat que le représentant de la compagnie aérienne n'apprécie pas exactement lorsque la décoration est mise en oeuvre en vraie grandeur sur l'avion.

Pour remédier à ces inconvénients, l'étape 200 peut comporter deux opérations supplémentaires.

L'une de ces opérations consiste à utiliser un logiciel, par exemple connu sous la marque CDRS, qui permet de manipuler des courbes rattachées à des surfaces. Grâce à ce type de logiciel, il est possible d'optimiser la projection de courbes sur des surfaces, par contrôle visuel, à partir de points prédéterminés de projection. Cette optimisation permet de s'assurer de l'harmonisation et de la continuité visuelle des courbes sur les parties fortement évolutives de la surface de l'avion, et surtout sur les interfaces entre différentes parties évolutives ou entre parties évolutives et parties planes (par exemple, le cône arrière de l'avion, la dérive, la pointe avant, etc.).

Cette mise au point de la visualisation de l'image de l'avion décoré peut être améliorée à tout moment par l'utilisation d'images de synthèse qui permettent une présentation réaliste de l'avion décoré, à la compagnie aérienne.

L'opération ultérieure de validation de la décoration est ainsi fortement simplifiée.

Lorsque la décoration est validée (réponse OUI à la question 200), son tracé est enregistré, à l'étape 300, par le système de traitement, dans une mémoire, sous forme de fichier informatique. Ce fichier contient des données relatives aux surfaces de l'avion, au tracé de la décoration, et notamment des données correspondant aux positions relatives du tracé et de la surface.

Tant que le tracé de la décoration n'est pas validé (réponse NON à la question 200), l'enregistrement n'est pas effectué et le tracé peut être modifié, comme décrit plus haut.

Afin de faciliter le positionnement et le calage ultérieur, par exemple de masques prédécoupés délimitant la peinture de la décoration sur l'avion, ou le positionnement d'éléments autocollants qui seront décrits plus loin, le fichier informatique peut aussi contenir des données de positionnement relatives à l'emplacement des portes, des hublots, des joints, des entrées d'air et autres éléments visibles sur l'avion.

Les données ainsi enregistrées dans le fichier informatique sont essentiellement des coordonnées de points du tracé de la décoration et de points de la surface de l'avion, mesurées dans un même repère de référence, lié à l'avion.

Après l'enregistrement effectué à l'étape 300, l'étape suivante 400 consiste, grâce à des moyens qui seront décrits plus loin en détail, à réaliser une première décoration prototype sur un avion, en utilisant les données de positionnement et de délimitation de la décoration, contenues dans le fichier informatique constitué à l'étape 300. Si cette décoration réelle est acceptée, (réponse OUI à la question 400), les données du fichier sont validées et peuvent être utilisées pour la décoration d'une série d'avions de même type appartenant à la compagnie aérienne concernée (étape 500). Si la décoration réelle n'est pas acceptée (réponse NON à la question 400), il est nécessaire de modifier le contenu du fichier, en revenant à l'étape 200. Les données relatives aux modifications, résultant de retouches du prototype de la décoration sur l'avion réel, sont bien entendu modifiées pour mettre à jour le fichier.

La création du fichier informatique (étape 200) contenant les données relatives aux modèles 3D de la surface de l'avion et du tracé de la décoration, va être maintenant décrite de manière plus détaillée.

La création du fichier 3D de la décoration à l'étape 200 comprend une phase préalable de conception ou de définition de la décoration.

A partir des souhaits de la compagnie aérienne, la définition de la décoration peut être établie soit à partir d'un dessin ou d'un tracé de la décoration dans un plan, en deux dimensions (par C.A.O. (2D) par exemple), soit par images de synthèse. Quel que soit le mode de définition choisi, chacun d'eux sert de base pour la validation de la décoration par la compagnie aérienne.

Dans le cas du tracé de la décoration sur un plan, c'est un support papier qui est utilisé. Ce plan peut d'ailleurs être obtenu à la sortie d'une imprimante reliée à un système de traitement par C.A.O. Plusieurs plans peuvent être nécessaires pour représenter des vues de face, de profil, de dessous, etc., de l'avion décoré. Des informations complémentaires sont ajoutées, par exemple des cotes, des références de couleurs, etc.

Dans le cas où la définition de la décoration se fait par C.A.O., un logiciel permet d'obtenir des images de synthèse, sous tous les angles, d'un avion non décoré. L'opérateur peut représenter directement les courbes de la décoration sur la surface de l'avion : tracé de bandes, utilisation de motifs issus d'une bibliothèque ou obtenus par tout autre procédé d'acquisition (scanner, photo, vidéo, etc.).

Le logiciel peut aussi permettre de réaliser des projections de la décoration par rapport à des points de visée fictifs qualifiés de points de contrôle, depuis lesquels les motifs de la décoration doivent avoir un aspect prédéfini.

L'avantage de cette représentation est d'obtenir l'effet qu'aura la décoration réelle sur l'avion. On s'affranchit ainsi de tous les problèmes d'illusion optique et d'incertitudes des vues en deux dimensions, afin de réduire les litiges avec la compagnie cliente. Lorsque la décoration ainsi définie est validée par la compagnie, il est alors nécessaire de figer cette décoration dans le fichier informatique (de type fichier obtenu à partir d'un logiciel de C.A.O) qui donne une définition précise de la décoration en trois dimensions (3D).

La peinture de la décoration est appliquée sur un avion qui est un support en relief, et le fichier 3D est indispensable pour commander un outillage de décoration précis. Cet outillage permet de reproduire fidèlement la décoration choisie et évite les erreurs de tracé dues à l'interprétation par le peintre, de plans 2D aux informations insuffisantes.

Le fichier 3D doit contenir :
- des données relatives à des points de calage permettant de faire coincider le référentiel (XYZ) du fichier informatique avec la surface de l'avion réel ;
- le tracé des décorations.

Trois méthodes peuvent être utilisées séparément ou conjointement pour obtenir le fichier 3D du tracé des décorations, à partir de trois sources différentes :

### A - A partir du plan 2D :

Dans le cas où la décoration a été choisie et validée à partir de plans C.A.O. ou papier 2D, il faut constituer un fichier 3D en projetant sur les surfaces de l'avion, les motifs et les bandes de décoration décrits sur le plan.

Il faut donc disposer préalablement d'un fichier C.A.O. (3D) des données relatives à la géométrie des surfaces extérieures de l'avion (C.A.O. surfacique ou volumique).

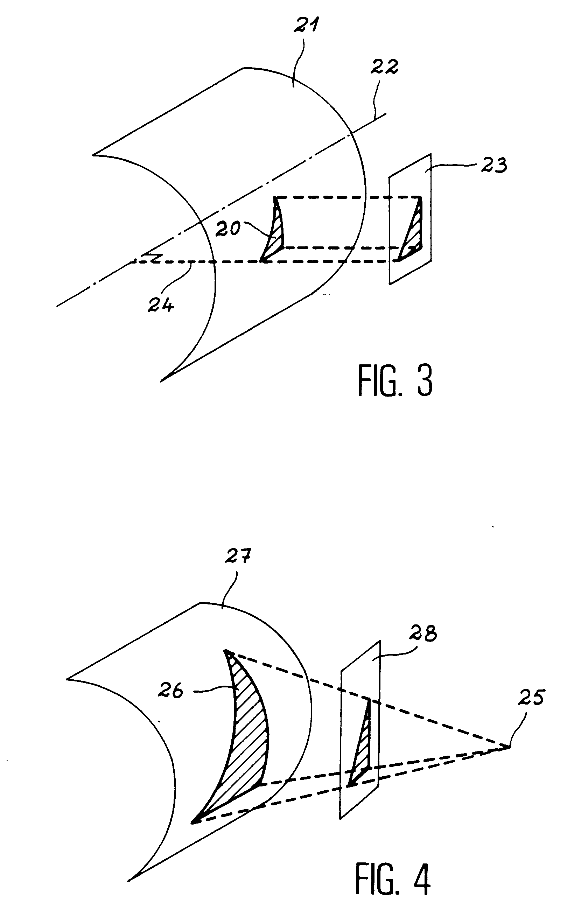

La projection "informatique" (c'est-à-dire effectuée en C.A.O. et apparaissant sur l'écran de visualisation d'un système de traitement) des motifs de la décoration sur la surface de l'avion, doit utiliser une méthodologie particulière :
- Sur les parties planes ou de forme faiblement évolutive (dérive, cylindre de fuselage par exemple), tel que représenté sur la figure 3, il est possible d'utiliser notamment une projection orthogonale. Le tracé du motif 20 de la décoration sur la surface 21 de l'avion (par exemple le fuselage ayant un axe de symétrie 22) est l'intersection d'un plan vertical 23 où le motif est tracé, avec la surface 21 de l'avion (surface 3D), suivant une direction 24 perpendiculaire à l'axe 22 de l'avion.
- Sur les parties évolutives (cône arrière, radome, etc.), la projection orthogonale décrite précédemment n'est pas satisfaisante, la décoration obtenue sur l'avion réel n'ayant pas l'aspect souhaité. En effet, les motifs de la décoration apparaissent déformés, par suite de la courbure des surfaces sur lesquelles ils sont tracés. Ainsi, une ligne rigoureusement horizontale sur le cône arrière, apparaît plongeante.

Il est nécessaire que les motifs de la décoration apparaissent, pour un observateur placé en un point prédéterminé de contrôle visuel, tels qu'ils sont tracés sur un plan.

Pour obtenir le fichier 3D qui correspond à cette exigence, il faut utiliser, comme le représente la figure 4, des projections coniques issues du point de visée 25. Dans ce cas, l'oeil fonctionne à la manière d'une lentille dont le foyer est la rétine. L'observateur voit le motif 26 de la décoration, tracé sur la surface 27 de l'avion, à partir du fichier 3D obtenu par cette méthode, tel que ce motif apparaît dans le plan 28, avec mise au point et validation en image de synthèse.

### B - A partir de l'avion réel déjà décoré :

Lorsqu'un avion est déjà décoré et que la décoration est acceptée par la compagnie aérienne, cette décoration peut servir de modèle pour les autres avions de même type de la même compagnie. Il est alors possible d'utiliser la photogrammétrie ou la mesure 3D par théodolithe pour effectuer des relevés permettant de constituer le fichier 3D de la décoration. La photogrammétrie utilise des photographies de cibles collées sur l'avion, tandis que la mesure par théodolithe utilise des intersections de visées.

Ces deux procédés permettent d'obtenir un fichier informatique des coordonnées x, y, z, de points qui permettent de repérer le positionnement ou la délimitation de la décoration sur l'avion.

L'avantage essentiel de cette méthode est que le fichier 3D de la décoration correspond aux exigences de la compagnie aérienne puisqu'il provient d'un avion réellement décoré et validé.

### C - A partir d'un modèle 3D, par dessin direct :

Au moyen du système de traitement, on conçoit directement, sans passer par le dessin ZD, les tracés et images qui vont permettre de présenter le projet de décoration à la compagnie cliente.

La réalisation d'une décoration prototype sur un avion réel, selon le procédé de l'invention, peut alors être effectuée, par exemple de la manière suivante : les points caractéristiques du tracé de la décoration sont projetés sur la surface de l'avion par des moyens optiques. Les coordonnées de ces points caractéristiques ont été mémorisées, comme décrit plus haut, dans le fichier informatique. Cette projection est effectuée par exemple à l'aide du télémètre laser 6 de la figure 1, après calage initial à l'aide de la lunette de visée, comme indiqué plus haut.

Les coordonnées des points caractéristiques déterminées et enregistrées par le système de traitement 4 peuvent être, selon un mode opératoire du procédé, lues sur un écran du système de traitement. Ces coordonnées peuvent aussi être enregistrées dans une mémoire propre au télémètre. Dans ce mode opératoire, un opérateur situé à proximité du télémètre laser 6 oriente manuellement le télémètre en utilisant des moyens de réglage incorporés pour que l'impact du faisceau du télémètre sur l'avion soit un point dont les coordonnées correspondent à celles qui sont lues sur l'écran et qui correspondent à un point caractéristique du tracé.

Selon un autre mode opératoire, la visée est automatique. Le télémètre comporte alors des moyens de commande de déplacement et d'orientation de la source lumineuse, connectés au système de traitement. Ces moyens commandent l'orientation automatique du faisceau laser pour qu'il soit dirigé vers les points caractéristiques du tracé qui doivent être repérés sur l'avion. Les moyens de commande de déplacement et d'orientation sont connus dans l'état de la technique et ne sont pas représentés sur la figure 1. Chaque point d'impact du faisceau du télémètre sur l'avion peut être sélectionné par l'opérateur, par exemple à l'aide d'une télécommande permettant d'indiquer le numéro du point qu'il est souhaitable de visualiser. De manière avantageuse, il est possible de repérer des points espacés par exemple de trente centimètres sur les surfaces planes de l'avion, et de dix centimètres lorsque les surfaces visées par le faisceau du télémètre sont évolutives.

Avant de réaliser cette projection lumineuse, il est nécessaire de définir des points de calage du télémètre ainsi que des zones de travail sur l'avion. En effet, il existe souvent un écart de géométrie entre le modèle théorique et l'avion réel. Pour s'affranchir de cet écart, on limite chaque projection lumineuse à des zones de travail successives, de dimensions relativement restreintes, qui peuvent être assimilées à des zones non-déformées.

Pour chaque zone de travail, l'opérateur repère un par un les points caractéristiques du tracé de la décoration sur l'avion. Le repérage de ces points permet de positionner un masque ou des adhésifs prédécoupés délimitant les lettres, signes distinctifs, logos, etc. constituant la décoration.

Après positionnement de masques ou d'adhésifs prédécoupés, la décoration de l'avion est effectuée par peinture des zones de la décoration ainsi délimitées. La décoration d'un premier avion étant achevée, elle est soumise à l'approbation de la compagnie aérienne. Dans le cas où la décoration du premier avion est acceptée, les autres avions de même type de la compagnie aérienne peuvent alors être décorés en série selon le même procédé en utilisant les données déjà mémorisées dans le fichier informatique. Dans le cas contraire, le procédé est repris, comme indiqué plus haut à l'étape 200, en tenant compte des modifications souhaitées par la compagnie aérienne. Ce cas est néanmoins peu probable puisque le tracé de la décoration a été préalablement approuvé et qu'il est peu concevable que l'effet de la décoration obtenue par visualisation sur l'écran d'un système de traitement soit différent de l'effet réel obtenu sur l'avion.

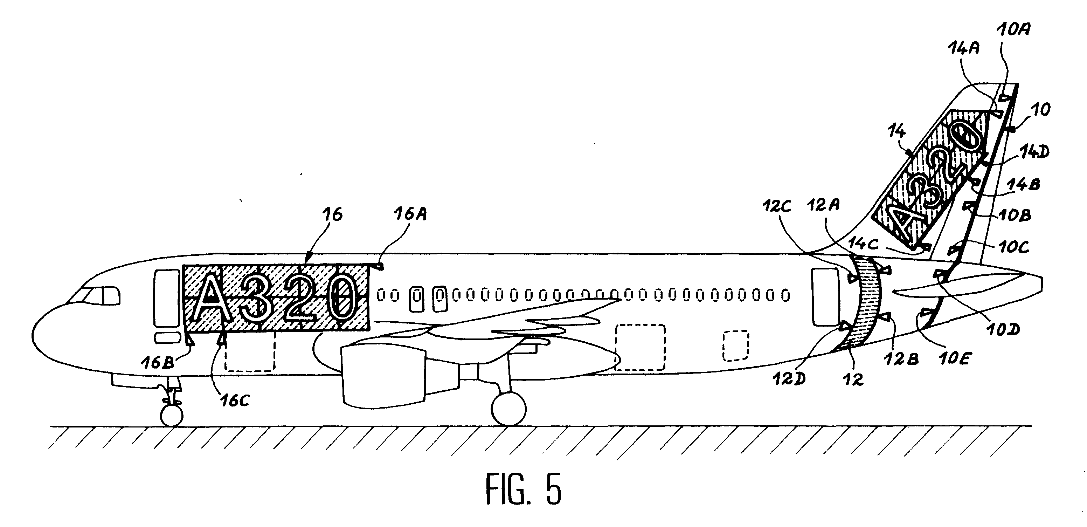

Sur la figure 5, on a représenté des exemples de tracé de décorations sur un avion. Plusieurs possibilités sont offertes, selon l'invention, pour délimiter et obtenir une décoration sur le fuselage de l'avion.

La première consiste à repérer des points caractéristiques par des index adhésifs ou des marques effaçables 10A, 10B, 10C, 10D et 10E. Ces points caractéristiques sont ensuite reliés par une bande ou un ruban adhésif 10 afin d'obtenir une ligne de délimitation de la décoration. Cette possibilité est essentiellement utilisée lorsque la décoration ne comporte que des bandes décoratives ou des figures décoratives de formes simples. Néanmoins, cette ligne de délimitation de la décoration peut aussi être utilisée comme ligne de repérage pour positionner un cache de délimitation de la peinture de la décoration, ce cache étant fixé par la bande adhésive 10.

Une autre possibilité consiste à appliquer un élément autocollant de décoration 12 dont l'emplacement est déterminé par des index adhésifs 12A, 12B, 12C, 12D positionnés à l'aide du télémètre. Les éléments autocollants peuvent se présenter sous forme prédécoupée. Ils représentent par exemple les attributs complexes identifiant la compagnie aérienne (lettres, logotypes, etc.), des marquages techniques, etc. Une autre possibilité consiste à localiser un pochoir 14 grâce à des index adhésifs 14A, 14B, 14C dont les positions sont repérées à l'aide du télémètre. La localisation de ce pochoir est effectuée après positionnement préalable d'une bande adhésive 14D.

Enfin, une autre possibilité consiste aussi à localiser un pochoir 16, grâce à des index adhésifs 16A, 16B, 16C, dont les positions sont repérées par le télémètre.

Selon un autre mode de réalisation du dispositif de l'invention, celui-ci comporte en outre un moyen 9 de projection d'images de la décoration, couplé au télémètre 6 (figure 1). Ce moyen de projection peut être de type vidéo. Il projette sur l'avion une image de la décoration en grandeur réelle. Cette image est obtenue à partir des données relatives à l'image de synthèse de la décoration, enregistrées dans le fichier informatique décrit plus haut. La position et la direction de projection de l'image de la décoration en grandeur réelle sur l'avion, sont déterminées au moyen d'un télémètre laser. Afin de limiter la déformation de l'image projetée de la décoration sur l'avion, notamment sur les surfaces de formes évolutives, la projection peut être effectuée selon des portions successives d'images de la décoration.

L'image projetée de la décoration permet, par exemple, de tracer les contours de cette décoration sur l'avion.

La pose de rubans, bandes, index ou pochoirs adhésifs mentionnés plus haut peut également être effectuée par un robot à bras manipulateur. Le déplacement du robot autour de l'avion ainsi que les positions du bras sont localisés par rapport à un repère de référence lié à l'avion et sont commandés par le système de traitement à partir des données enregistrées dans le fichier informatique. Le robot peut également déposer un film de masquage délimitant les zones à peindre. Ce film peut être constitué d'un matériau polymère adhérent délivré par un distributeur dont le débit est quantifié pour que la polymérisation intervienne au fur et à mesure de l'avancement du distributeur.

Il est également possible d'utiliser un masque "pelable" constitué d'une couche sensible adhérent à l'objet, découpée par faisceau laser adapté à cette fonction, guidé par le télémètre, de façon à délimiter le tracé de la décoration. Le découpage de la couche sensible permet d'enlever les zones de couches sensibles correspondant aux zones à peindre pour obtenir la décoration, tout en laissant en place la zone sensible protectrice qui permet l'application de la peinture. La couche protectrice est ensuite retirée lorsque le cycle de séchage de la peinture est terminé.

Le procédé et le dispositif qui viennent d'être décrits peuvent, bien entendu, être appliqués à la décoration de tout autre objet qu'un avion.

## Revendications

1. Procédé d'aide à la réalisation du tracé d'une décoration sur un objet, consistant à :
- obtenir (100) un modèle en trois dimensions (3D) de l'objet à décorer ;
- obtenir un modèle (3D) du tracé de la décoration sur l'objet ;
- localiser sur le modèle (3D) de l'objet à décorer certains points caractéristiques du tracé de la décoration, à partir du modèle (3D) de l'objet et du modèle (3D) du tracé de la décoration ;
**caractérisé en ce qu'**il consiste dans un système de conception assistée par ordinateur (CAO) :
- en une utilisation d'un logiciel capable de commander ce système pour obtenir des modèles (3D) de type surfacique ou volumique de l'objet à décorer et de la décoration, visualisables respectivement en au moins une image, ces images étant définies par des données enregistrées dans des fichiers ;
- en une superposition, à l'aide dudit logiciel, des modèles (3D) de type surfacique ou volumique de l'objet à décorer et de la décoration, pour obtenir au moins une image (3D) de l'objet décoré, la localisation de l'image de la décoration sur l'image de l'objet étant définie à partir desdits points caractéristiques, les données relatives à l'image de l'objet décoré obtenues à partir dudit logiciel étant enregistrées dans un fichier apte à être exploité par des moyens de positionnement du tracé de la décoration sur l'objet.

2. Procédé selon la revendication 1, **caractérisé en ce qu'**il consiste à modéliser l'objet décoré :
- par construction d'un modèle mathématique (3D) de l'objet à décorer, ce modèle étant obtenu à partir de mesures géométriques directes sur l'objet, le modèle (3D) étant alors visualisable par au moins une image ;
- par superposition audit modèle de l'objet, d'au moins un modèle mathématique (3D) du tracé de la décoration souhaité de l'objet, visualisable par au moins une image.

3. Procédé selon la revendication 1, **caractérisé en ce qu'**il consiste à positionner sur l'objet des moyens de délimitation de la décoration (10 ou 14 ou 16), à partir desdits points caractéristiques localisés sur l'objet.

4. Dispositif d'aide à la décoration d'un objet tridimensionnel, **caractérisé en ce qu'**il comporte :
- un système (4) de traitement de données commandé par un logiciel spécialisé de Conception Assistée par Ordinateur pour obtenir une représentation tridimensionnelle d'un modèle mathématique de l'objet (2) à décorer, et une représentation tridimensionnelle, d'un modèle mathématique du tracé de la décoration souhaitée de l'objet, le modèle du tracé de la décoration étant superposé au modèle de l'objet, les représentations (3D) des modèles de l'objet et de la décoration étant de type surfacique ou volumique ;
- des moyens de mémorisation reliés au système de traitement pour enregistrer des coordonnées d'au moins une pluralité de points caractéristiques du tracé de la décoration, repérés par rapport à des points de référence de l'objet ;
- des moyens (6) pour localiser sur ledit objet, au moins les points caractéristiques (10A-10E) du tracé de la décoration, à partir desdites coordonnées enregistrées.

5. Dispositif selon la revendication 4, **caractérisé en ce que** les moyens pour localiser lesdits points caractéristiques sur ledit objet (6), sont des moyens de projection lumineuse desdits points sur ledit objet.

6. Dispositif selon la revendication 5, caractérisé ce que les moyens de projection lumineuse comportent une source lumineuse et des moyens de commande de déplacement et d'orientation de la source lumineuse pour projeter sur l'objet lesdits points caractéristiques du tracé, à partir desdites coordonnées enregistrées.

7. Dispositif selon la revendication 6, **caractérisé en ce que** les moyens de commande de déplacement et d'orientation de la source lumineuse sont reliés au système de traitement (4).

8. Dispositif selon la revendication 5 ou 6, **caractérisé en ce que** la source lumineuse est une source laser.

9. Dispositif selon la revendication 5, **caractérisé en ce qu'**il comporte des index adhésifs ou des marques (10A, 10E) effaçables pour repérer lesdits points caractéristiques localisés sur l'objet par projection lumineuse.

10. Dispositif selon la revendication 9, **caractérisé en ce qu'**il comporte des moyens de délimitation de la décoration (10, 12, 14, 16) positionnés sur l'objet, à partir des positions desdits index ou marques de repérage (10A, 10E).

11. Dispositif selon la revendication 10, **caractérisé en ce que** lesdits moyens de délimitation de la décoration sont des bandes adhésives ou des pochoirs.

12. Dispositif selon la revendication 10, **caractérisé en ce que** lesdits moyens de délimitation de la décoration sont des éléments autocollants.

13. Dispositif selon la revendication 4, **caractérisé en ce que** les moyens pour localiser lesdits points caractéristiques sur ledit objet sont des moyens de projection d'image de la décoration sur ledit objet.

14. Dispositif selon la revendication 4, caractérisé ce que les moyens pour localiser le tracé de la décoration sur ledit objet comportent un moyen de découpage d'une couche sensible adhérant à l'objet, pour faire apparaître des zones de cette couche correspondant à des zones de la décoration, lesdites zones de la couche sensible étant pelables.

15. Dispositif selon la revendication 4, **caractérisé en ce qu'**il comporte des moyens commandés par ledit système de traitement pour distribuer un matériau à la surface dudit objet, un film de masquage délimitant la décoration, ce film étant constitué par un matériau polymérisable.

16. Dispositif selon la revendication 4, **caractérisé en ce qu'**il comporte des moyens commandés par le système de traitement pour poser des bandes, pochoirs ou index adhésifs de repérage ou de délimitation de la décoration.

## Claims

1. Method for assisting in the production of the layout of a decoration on an object consisting of:
- obtaining (100) a three-dimensional (3D) model of the object to be decorated,
- obtaining a 3D model of the layout of the decoration on the object,
- localizing on the 3D model of the object to be decorated certain characteristic points of the decoration layout, on the basis of the 3D model of the object and the 3D model of the decoration layout,
**characterized in that** in a computer assisted design (CAD) system it consists of:
- using a software able to control this system in order to obtain 3D models of the surface or volume type of the object to be decorated and of the decoration, which can be displayed respectively in at least one image, said images being defined by data recorded in files,
- superimposing, with the aid of software, 3D models of the surface or volume type of the object to be decorated and the decoration, in order to obtain at least one 3D image of the decorated object, the localization of the image of the decoration on the image of the object being defined on the basis of said characteristic points, the data relative to the image of the decorated object obtained on the basis of said software being recorded in a file usable by means for positioning the layout of the decoration on the object.

2. Method according to claim 1, **characterized in that** it consists of modelling the decorated object:
- by constructing a 3D mathematical model of the object to be decorated, said model being obtained from direct geometrical measurements on the object, the 3D model then being able to be displayed by at least one image;
- by superimposing on said model of the object at least one 3D mathematical model of the plotting of the desired decoration of the object and able to be displayed by at least one image.

3. Method according to claim 1, **characterized in that** it consists of positioning means on the object, said means used for delimiting the decoration (10 or 14 or 16) from said characteristic points localized on the object.

4. Device for decorating a tridimensional object, **characterized in that** it comprises:
- a data processing system (4) controlled by a specialized Computer Assisted Design software so as to obtain a tridimensional representation of a mathematical model of the object (2) to be decorated and tridimensional representation of a mathematical model of the plotting of the desired decoration of the object, the model of the decoration plotting being superimposed on the model of the object;
- storage means connected to the processing system so as to record the coordinates of at least a plurality of characteristic points of the plotting of the decoration and marked with respect to reference points of the object;
- means (6) to localize on said object at least the characteristic points (10A-10E) of the plotting of the decoration from said recorded coordinates.

5. Device according to claim 4, **characterized in that** the means to localize said characteristic points on said object are means for the luminous projection of said points onto said object.

6. Device according to claim 5, **characterized in that** the luminous projection means comprise a luminous source and means for controlling the movement and orientation of the luminous source so as to project onto the object said characteristic points of the plotting on the basis of said recorded coordinates.

7. Device according to claim 6, **characterized in that** the means for controlling the movement and orientation of the luminous source are connected to the processing system (4).

8. Device according to claim 5 or 6, **characterized in that** the luminous source is a laser source.

9. Device according to claim 5, **characterized in that** it comprises adhesive indices or erasable marks (10A, 10E) so as to mark said characteristic points localized on the object by means of luminous projection.

10. Device according to claim 9, **characterized in that** it comprises means for delimiting the decoration (10, 12, 14, 16) positioned on the object from the positions of said marking marks or indices (10A, 10E).

11. Device according to claim 10, **characterized in that** said decoration delimiting means are adhesive strips or stencils.

12. Device according to claim 10, **characterized in that** said decoration delimiting means are self-adhesive elements.

13. Device according to claim 4, **characterized in that** the means to localize said characteristic points on said object are means for projecting an image of the decoration onto said object.

14. Device according to claim 4, **characterized in that** the means to localize the plotting of the decoration on said object comprise a device for cutting a sensitive film adhering to the object so as to have appear zones of this film corresponding to the decoration zones, said zones of the sensitive film being peelable.

15. Device according to claim 4, **characterized in that** it comprises a robot for distributing a polymerizable material in the form of a masking film on the surface of said object, this film delimiting the decoration and the robot being controlled by said processing system.

16. Device according to claim 4, **characterized in that** it comprises a robot controlled by the processing system so as to lay down strips, stencils or adhesive indices for marking or delimiting the decoration.

## Patentansprüche

1. Verfahren zur Unterstützung der Erstellung einer Linienführung einer Dekoration auf einem Gegenstand, umfassend:
Erstellen (100) eines dreidimensionalen (3D) Modells des zu dekorierenden Gegenstands,
Erstellen eines 3D-Modells der Dekorationslinie auf dem Gegenstand,
Lokalisieren bestimmter charakteristischer Punkte der Dekorationslinie auf dem 3D-Modell des Gegenstands anhand des 3D-Modells des Gegenstands und des 3D-Modells der Linienführung der Dekoration,
**dadurch gekennzeichnet, daß** es in einem computergestützten Designsystem (CAO = conception assistée par ordinateur) besteht aus:
der Verwendung einer Software, die dieses System zu steuern vermag, um auf die Oberfläche oder das Volumen bezogene 3D-Modelle des zu dekorierenden Gegenstands und der Dekoration zu erhalten, welche jeweils in mindestens einem Bild sichtbar gemacht werden können, wobei diese Bilder durch in Dateien aufgezeichnete Daten definiert sind bzw. werden,
einer Überlagerung, mittels der Software, der auf die Oberfläche oder das Volumen bezogenen 3D-Modelle des zu dekorierenden Gegenstands und der Dekoration, um mindestens ein 3D-Bild des dekorierten Gegenstands zu erhalten, wobei die Lokalisierung des Bildes der Dekoration auf dem Bild des Gegenstands anhand der charakteristischen Punkte festgelegt wird und die Daten hinsichtlich des anhand der Software erhaltenen Bildes des dekorierten Gegenstands in einer Datei aufgezeichnet werden, die von Mitteln zur Positionierung der Linienführung der Dekoration auf dem Gegenstand ausgewertet zu werden vermag.

2. Verfahren nach Anspruch 1, **dadurch gekennzeichnet, daß** es im Modellieren des dekorierten Gegenstands besteht:
- durch Konstruieren eines mathematischen 3D-Modells des zu dekorierenden Gegenstands, wobei das Modell anhand von direkten geometrischen Messungen am Gegenstand gewonnen wird und das 3D-Modell dabei durch mindestens ein Bild sichtbar gemacht wird,
- durch Überlagern mindestens eines mathematischen 3D-Modells der Linienführung der gewünschten Dekoration des Gegenstands auf das Modell des Gegenstands, das durch mindestens ein Bild sichtbar gemacht wird.

3. Verfahren nach Anspruch 1, **dadurch gekennzeichnet, daß** es darin besteht, anhand der auf dem Gegenstand lokalisierten charakteristischen Punkte auf dem Gegenstand Begrenzungsmittel der Dekoration (10 oder 14 oder 16) zu positionieren.

4. Vorrichtung zur Unterstützung der Dekoration eines dreidimensionalen Gegenstands, **dadurch gekennzeichnet, daß** sie umfaßt:
ein Datenverarbeitungssystem (4), das von einer speziellen Software für computerunterstütztes Design (Conception Assistée par Ordinateur) gesteuert wird, um eine dreidimensionale Darstellung eines mathematischen Modells des zu dekorierenden Gegenstands (2) zu erhalten, sowie
eine dreidimensionale Darstellung eines mathematischen Modells der gewünschten Linienführung der Dekoration auf dem Gegenstand, wobei das Modell der Linienführung der Dekoration dem Modell des Gegenstands überlagert ist bzw. wird und die 3D-Darstellungen der Modelle des Gegenstands und der Dekoration oberflächenbezogen oder volumenbezogen sind,
mit dem Verarbeitungssystem verbundene Speichermittel, um Koordinaten von mindestens einer Mehrzahl charakteristischer Punkte der Linienführung der Dekoration, die in Bezug auf Bezugspunkte des Gegenstands festgelegt sind, aufzuzeichnen,
Mittel (6) zum Lokalisieren mindestens der charakteristischen Punkte (10A-10E) der Linienführung der Dekoration auf dem Gegenstand anhand der aufgezeichneten Koordinaten.

5. Vorrichtung nach Anspruch 4, **dadurch gekennzeichnet, daß** die Mittel zum Lokalisieren der charakteristischen Punkte auf dem Gegenstand (6) Mittel zur Lichtprojektion der Punkte auf den Gegenstand sind.

6. Vorrichtung nach Anspruch 5, **dadurch gekennzeichnet, daß** die Mittel zur Lichtprojektion eine Lichtquelle sowie Mittel zum Steuern der Verschiebung und der Orientierung der Lichtquelle umfassen, um die charakteristischen Punkte der Linienführung anhand der aufgezeichneten Koordinaten auf den Gegenstand zu projizieren.

7. Vorrichtung nach Anspruch 6, **dadurch gekennzeichnet, daß** die Mittel zum Steuern der Verschiebung und der Orientierung der Lichtquelle mit dem Verarbeitungssystem (4) verbunden sind.

8. Vorrichtung nach Anspruch 5 oder 6, **dadurch gekennzeichnet, daß** die Lichtquelle eine Laserquelle ist.

9. Vorrichtung nach Anspruch 5, **dadurch gekennzeichnet, daß** sie Klebe-Indexmarken oder löschbare Marken (10A,10E) umfaßt, um die durch Lichtprojektion auf dem Gegenstand lokalisierten charakteristischen Punkte zu orten.

10. Vorrichtung nach Anspruch 9, **dadurch gekennzeichnet, daß** sie Mittel (10,12,14,16) zum Begrenzen der Dekoration umfaßt, die auf dem Gegenstand anhand der Positionen der Indexmarken oder Ortungsmarken (10A,10E) positioniert sind bzw. werden.

11. Vorrichtung nach Anspruch 10, **dadurch gekennzeichnet, daß** die Mittel zum Begrenzen der Dekoration Klebebänder oder Schablonen sind.

12. Vorrichtung nach Anspruch 10, **dadurch gekennzeichnet, daß** die Mittel zum Begrenzen der Dekoration selbstklebende Elemente sind.

13. Vorrichtung nach Anspruch 4, **dadurch gekennzeichnet, daß** die Mittel zum Lokalisieren der charakteristischen Punkte auf dem Gegenstand Mittel zum Projizieren eines Bildes der Dekoration auf den Gegenstand sind.

14. Vorrichtung nach Anspruch 4, **dadurch gekennzeichnet, daß** das Mittel zum Lokalisieren der Linienführung der Dekoration auf dem Gegenstand ein Mittel zum Wegschneiden einer am Gegenstand klebenden empfindlichen Schicht ist, um Bereiche dieser Schicht in Erscheinung treten zu lassen, die Dekorationsbereichen entsprechen, wobei die Bereiche der empfindlichen Schicht ablösbar sind.

15. Vorrichtung nach Anspruch 4, **dadurch gekennzeichnet, daß** sie Mittel umfaßt, die von dem Verarbeitungssystem gesteuert werden, um ein Material an der Oberfläche des Gegenstands aufzubringen, wobei ein Maskierungsfilm die Dekoration begrenzt und der Film aus einem poymerisierbaren Material besteht.

16. Vorrichtung nach Anspruch 4, **dadurch gekennzeichnet, daß** sie Mittel umfaßt, die von dem Verarbeitungssystem gesteuert werden, um Bänder, Schablonen oder Klebe-Indexmarken zum Orten oder zum Begrenzen der Dekoration anzubringen.
